# EUROPEAN PATENT APPLICATION

(11) **EP 1 729 337 A2**
(43) Date of publication of application: **06.12.2006**
(21) Application number: 06252847.6
(22) Date of filing: 01.06.2006
(51) Int. Cl.: H01L 21/70, H01L 23/28, H05K 1/18, H05K 3/30, H05K 3/34

(54) **Electronic device and method of manufacturing the same**

(30) Priority: 03.06.2005 JP 2005164387
(71) Applicant: SHINKO ELECTRIC INDUSTRIES CO., LTD., Nagano-shi, Nagano 381-2287 (JP)
(72) Inventor: Otsuka, Takashi, Nagano-shi, Nagano 381-2287 (JP)
(74) Representative: Finnie, Peter John

(57) **Abstract**

An electronic device includes a substrate (23) on which foot patterns (24A,24B) and a solder resist (25) are provided such that the foot patterns (24A,24B) are exposed from opening portions (27A,27B) in the solder resist (25), packaging parts (20A,20B) mounted on the substrate (23) by solder (26), and a sealing resin (29) formed on the substrate (23) to seal the packaging parts (20A,20B), wherein a part (running-on portions 26A,26B) of the solder (26) is constructed to run on an upper surface of the solder resist (25) under the packaging parts (20A,20B).

## Description

### TECHNICAL FIELD

The present disclosure relates to an electronic device and a method of manufacturing the same. More particularly, the present disclosure relates to an electronic device having such a structure that a packaging part is mounted on a substrate by using solder, and a method of manufacturing the same.

### RELATED ART

In recent years, the demand for miniaturization of the electronic device is increasing. Accordingly, in order to mount the packaging device provided in the electronic device on the substrate, a necessity to use the surface mounting and the flip-chip mounting is increased (see JP-A-2005-109187, for example).

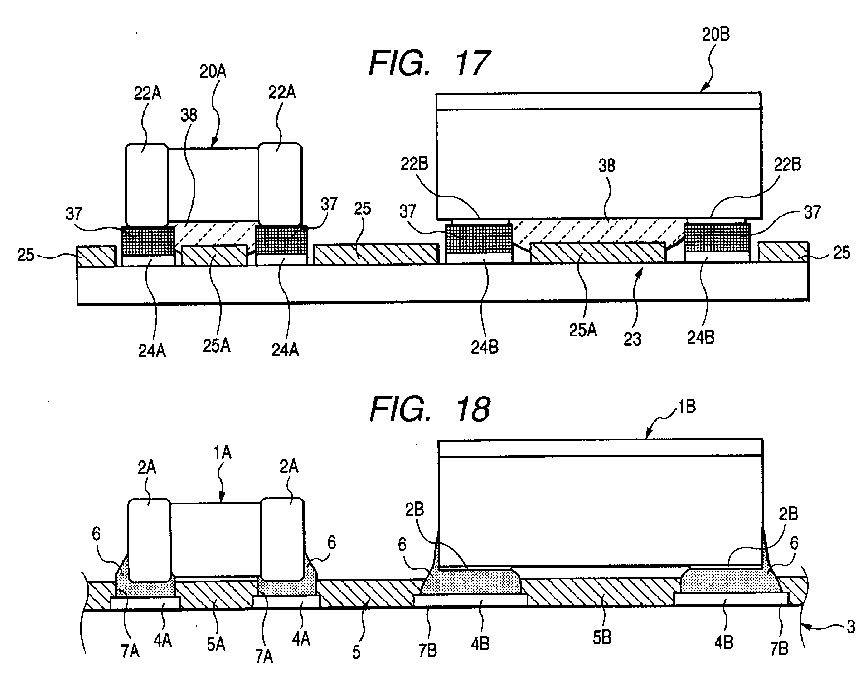

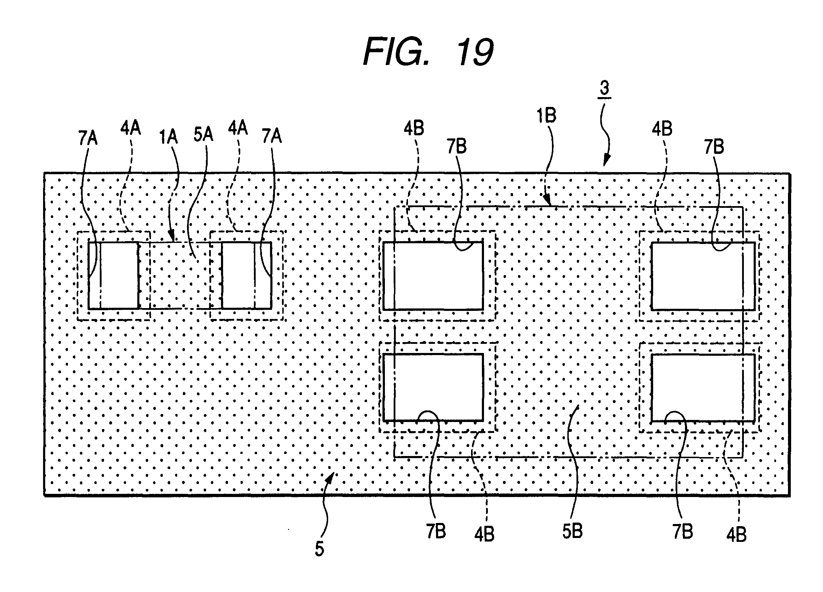

An example of the surface mounting will be explained with reference to FIG.18 to FIG.23 hereunder. FIG.18 shows an electronic device as a first related-art example. FIG. 19 shows a substrate 3 used in the electronic device as the first related-art example. Foot patterns 4A, 4B onto which packaging parts 1A, 1B are soldered respectively are formed on a surface of the substrate 3. Also, various wiring patterns (not shown) as well as to the foot patterns 4A, 4B are formed on the surface of the substrate 3. A solder resist 5, 5A, 5B is formed on the surface of the substrate 3 to protect the wiring patterns.

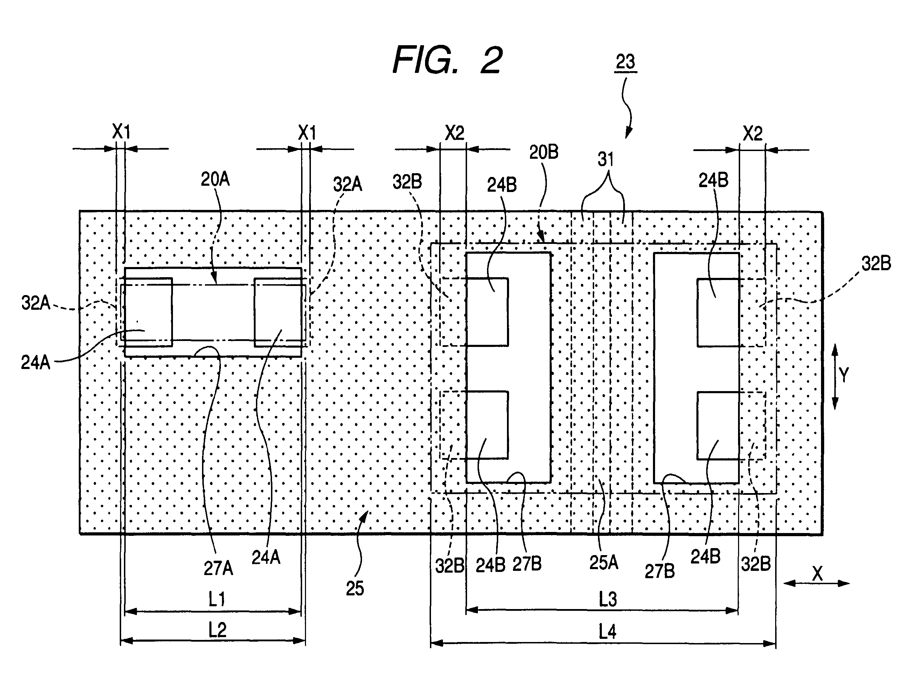

The solder resist 5, 5A, 5B is a resin having an insulating performance and, as shown in FIG.2, opening portions 7A, 7B are formed in positions opposing to the foot patterns 4A, 4B. Therefore, the foot patterns 4A, 4B are exposed from the solder resist 5 in positions in which the opening portions 7A, 7B are formed.

The packaging parts 1A, 1B are surface-mounted on the foot patterns 4A, 4B, which are exposed from the opening portions 7A, 7B in the solder resist 5, with solder 6. More particularly, a packaging -part electrode 2A is provided to both side portions respectively because the packaging part 1A is a ceramic chip part. Also, the packaging part 1B is an electronic element such as an oscillator, or the like, and packaging part electrodes 2B are formed on a lower surface of the packaging part 1B. Then, when these packaging parts are mounted, the solder paste is applied previously to the foot patterns 4A, 4B, and then the packaging parts 1A, 1B are mounted on the substrate 3 such that respective electrodes 2A, 2B are positioned on the foot patterns 4A, 4B to which the solder paste is applied. Then, the packaging parts 1A, 1B are surface-mounted on the substrate 3 with solder 6 by executing the reflow process under this condition.

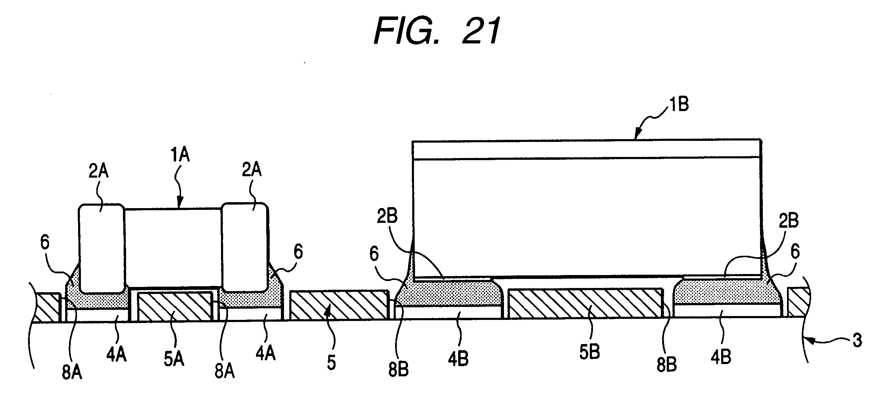

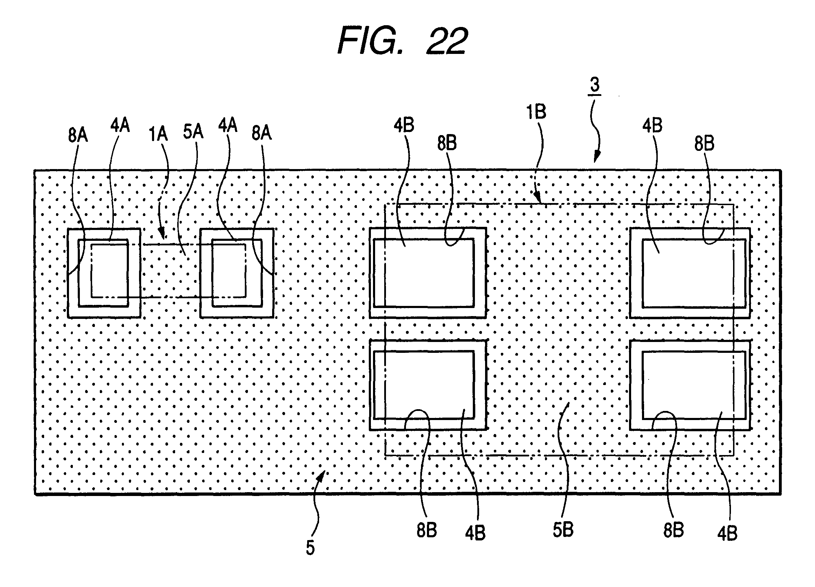

An electronic device shown in FIG.21 has the almost same structure as the electronic device shown in FIG.18. However, the electronic device shown in FIG.18 is constructed in such a manner that areas of the opening portions 7A, 7B formed in the solder resist 5 are smaller than areas of the foot patterns 4A, 4B respectively and that outer peripheral portions of the foot patterns 4A, 4B are covered with the solder resist 5. In contrast, the electronic device shown in FIG.21 is constructed such that the areas of the opening portions 8A, 8B formed in the solder resist 5 are set larger than the areas of the foot patterns 4A, 4B respectively and thus overall areas of the foot patterns 4A, 4B are exposed from the solder resist 5 (see FIG. 22).

Meanwhile, as shown in FIG.18 and FIG.21, many electronic devices in the related art are constructed such that the packaging parts 1A, 1B are mounted on the substrate 3 in their exposed state, i.e., in their uncovered state. However, since other people can easily know how the packaging parts 1A, 1B and the wiring patterns are arranged and constructed, these uncovered packaging structures have the problem in terms of the know-how protection.

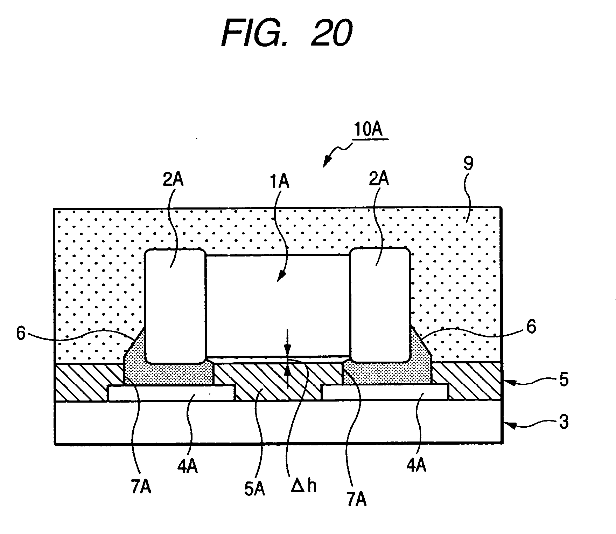

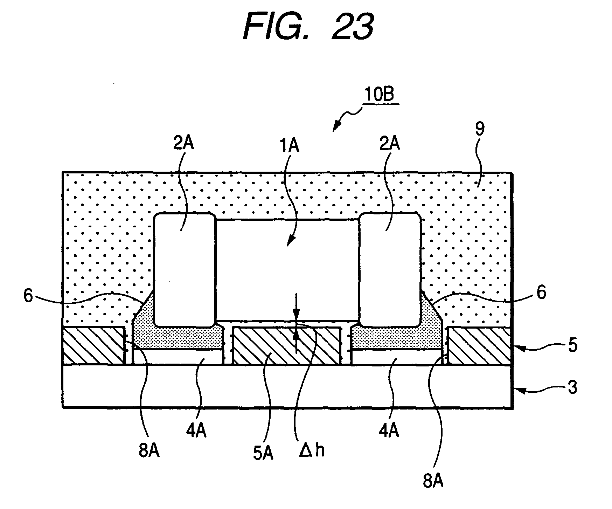

As the means for preventing this problem, as shown in FIG.20 and FIG.23, it may be considered that the packaging parts (only the packaging parts 1A is illustrated in FIG.20 and FIG. 23) are sealed with a sealing resin 9. In electronic devices 10A, 10B constructed in this manner, the sealing resin 9 formed of an opaque resin makes it possible to prevent the arrangements and structures of the packaging parts 1A, 1B and the wiring patterns from being seen from the outside.

However, a minute clearance (indicated with an arrow Δh in respective Figures) is formed between the packaging part 1A, when mounted on the substrate 3, and the solder resist 5A, 5B. A magnitude of this clearance Δh is varied due to a size of the packaging part 1A, an applied amount of the solder 6, and the like, and is given by almost 5 to 10 µm, for example.

In this manner, when a minute clearance is formed between the packaging part 1A and the solder resist 5A (substrate 3), the sealing resin 9 cannot enter into such minute clearance when the sealing resin 9 is provided. As a result, a void in which the sealing resin 9 is not provided is generated between the packaging part 1A and the solder resist 5A.

In the case where the void is generated in the sealing resin 9, when a heating process is carried out in mounting the electronic devices 10A, 10B and the solder 6 is melted, the periphery of the solder 6 is sealed with the sealing resin 9. Therefore, it is possible that the melted solder 6 enters into the clearance and thus the short-circuit is generated between the packaging part electrodes 2A. Also, there is a possibility that an air in the clearance is expanded by the heating and thus cracks are generated in the sealing resin 9.

### SUMMARY

The disclosure below describes an electronic device capable of preventing not only generation of a short-circuit between electrode patterns during heating but also generation of cracks in a sealing resin by increasing an isolation distance between a packaging part and a substrate, and a method of manufacturing the same.

An example implementation of the invention is described below.

An electronic device, comprises:
a substrate on a surface of which electrode patterns and a solder resist are provided such that the electrode patterns are exposed from opening portions formed in the solder resist;
a packaging part mounted on the substrate, the packaging part having packaging part electrodes connected to the electrode patterns by solder; and
a sealing resin formed on the substrate to seal the packaging part;
wherein a part of the solder runs on an upper surface of the solder resist.

In the above-mentioned structure, since a part of the solder runs on an upper surface of the solder resist, an isolation distance between the packaging part and the substrate can be set large. Therefore, the sealing resin can be injected surely into spaces between the packaging part and the substrate.

Also, in the electronic device, when the substrate is viewed from a top, the solder resist may have overlapping portions that are overlapped with areas in which the packaging part electrodes and the electrode patterns oppose to each other.

In the above-mentioned structure, the overlapping portions that are overlapped with areas where the packaging part electrodes and the electrode patterns oppose to each other are provided to the solder resist. Therefore, a part of the solder can be caused easily to run on the upper surface of the solder resist (overlapping portions).

Also, in the electronic device, the solder resist may not be provided in an area in which the packaging part and the substrate oppose to each other.

In the above-mentioned structure, the packaging part opposes directly to the substrate and the solder resist is not present between them. Therefore, a height of the packaging part from the substrate can be set further large, and thus the sealing resin can be injected more surely into the spaces between the packaging part and the substrate.

Also, an electronic device, .comprises:
a substrate on a surface of which electrode patterns and a solder resist are provided such that the electrode patterns are exposed from opening portions formed in the solder resist;
a packaging part mounted on the substrate, the packaging part having packaging part electrodes connected to the electrode patterns by solder; and
a sealing resin formed on the substrate to seal the packaging part;
packaging part electrode wherein a buried member is provided into the electrode patterns respectively in a state that it is buried in the solder.

In the above-mentioned structure, since the buried member buried in the solder is provided into the electrode patterns respectively, the buried member is buried in the inside of the solder when the solder is applied to the electrode patterns. Therefore, a height of the solder is increased higher than a height obtained when the buried member is not provided. As a result, an isolation distance between the packaging part and the substrate can be set large and thus the sealing resin can be injected without fail into the spaces between the packaging part and the substrate.

Also, in the electronic device, the buried member is formed of the solder resist.

In the above-mentioned structure, the buried member is formed of the solder resist. Therefore, the buried member can be formed at the same time when the solder resist is formed.

Also, in the electronic device, when the substrate is viewed from a top, the buried member is provided to areas in which the packaging part electrodes and the electrode patterns oppose to each other.

In the above-mentioned structure, the buried member is provided to the areas where the packaging part electrodes oppose to the electrode patterns. Therefore, the buried member can be provided without fail to the inside of the solder.

Also, a method of manufacturing an electronic device, comprises: steps of
applying solder to electrode patterns on a substrate on a surface of which the electrode patterns and a solder resist are provided such that the electrode patterns are exposed from opening portions formed in the solder resist; mounting packaging part electrodes, which are provided to a packaging part, on the electrode patterns by using the solder; and
forming a sealing resin, which seals the packaging part, on the substrate;
wherein, before the mounting step is executed, a thermosetting adhesive having an activation power necessary for soldering is provided to a position corresponding t.o a mounting position of the substrate, on which the packaging part is mounted.

In the above-mentioned structure, since a thermosetting adhesive having an activation power necessary for the soldering is provided before the mounting step is executed, the packaging part can be secured to the substrate by using this adhesive in the mounting step. Also, since the solder is activated by the activator contained in the adhesive when the packaging part is soldered to the wiring patterns in the mounting step, the soldering can be executed without fail. In addition, since the adhesive is present between the packaging part and the substrate in the sealing step, no clearance is generated between the packaging part and the substrate when the sealing resin is formed.

Various implementations may include one or more the following advantages. For example, since an isolation distance between the packaging part and the substrate can be set large, the sealing resin can be introduced surely into the spaces between the packaging part and the substrate. Thus, even when the sealing resin is formed, no clearance is generated between the packaging part and the substrate. Therefore, it can be prevented that a short-circuit between the packaging parts patterns via the solder entered into the clearance is generated, and also it can be prevented that an air in the clearance is expanded by heating to exert a bad influence upon the sealing resin, and the like. As a result, reliability of the electronic device can be improved.

### BRIEF DESCRIPTION OF THE DRAWINGS

FIG.1 is a side view showing a state before a sealing resin is provided to an electronic device as a first embodiment of the present invention. FIG.2 is a plan view of a substrate constituting the electronic device as the first embodiment of the present invention.
FIG.3 is a sectional view of the electronic device as the first embodiment of the present invention.
FIG. 4 is a plan view showing .a variation of a substrate constituting the electronic device as the first embodiment of the present invention.
FIG.5 is a side view showing a state before a sealing resin is provided to an electronic device as a second embodiment of the present invention.
FIG.6 is a plan view of a substrate constituting the electronic device as the second embodiment of the present invention.
FIG.7 is a sectional view of the electronic device as the second embodiment of the present invention.
FIG.8 is a sectional view of an electronic device as a third embodiment of the present invention.
FIG.9 is a view (#1) explaining a method of manufacturing the electronic device as the third embodiment.
FIG.10 is a view (#2) explaining the method of manufacturing the electronic device as the third embodiment.
FIG.11 wis a view (#3) explaining the method of manufacturing the electronic device as the third embodiment.
FIG.12 is a sectional view of an electronic device as a fourth embodiment of the present invention.
FIG.13 is a view (#1) explaining a method of manufacturing the electronic device as the fourth embodiment.
FIG. 14 is a view (#2) explaining the method of manufacturing the electronic device as the fourth embodiment.
FIG. 15 is a view (#3) explaining the method of manufacturing the electronic device as the fourth embodiment.
FIG. 16 is a view (#1) explaining a variation of a method of manufacturing the electronic device as the fourth embodiment.
FIG.17 is a view (#2) explaining the variation of the method of manufacturing the electronic device as the fourth embodiment.
FIG.18 is a side view showing a state before a sealing resin is provided to an electronic device as a first related-art example.
FIG.19 is a plan view of a substrate constituting the electronic device as the first related-art example.
FIG.20 is a sectional view of the electronic device as the first related-art example.
FIG.21 is a side view showing a state before a sealing resin is provided to an electronic device as a second related-art example.
FIG.22 is a plan view of a substrate constituting the electronic device as the second related-art example.
FIG.23 is a sectional view of the electronic device as the second related-art example.

### DETAILED DESCRIPTION

Next, the best mode for carrying out the present invention will be explained with reference to the drawings hereinafter.

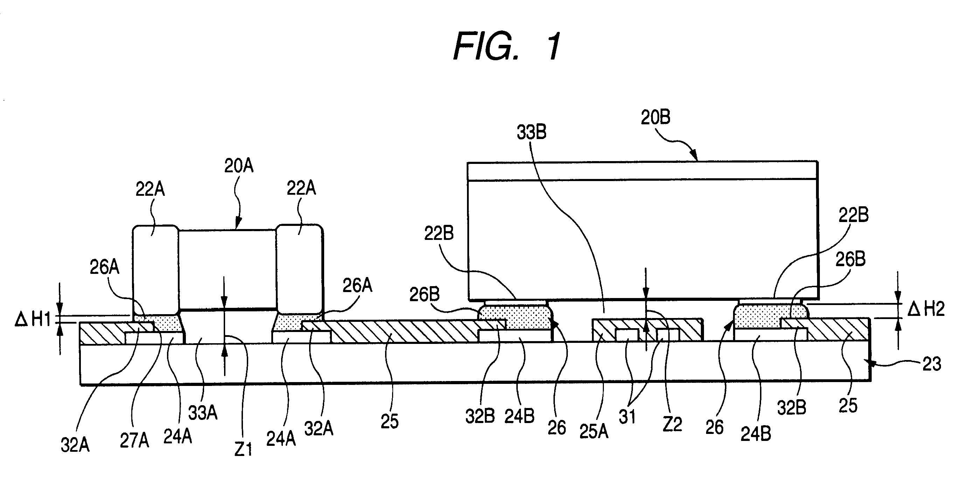

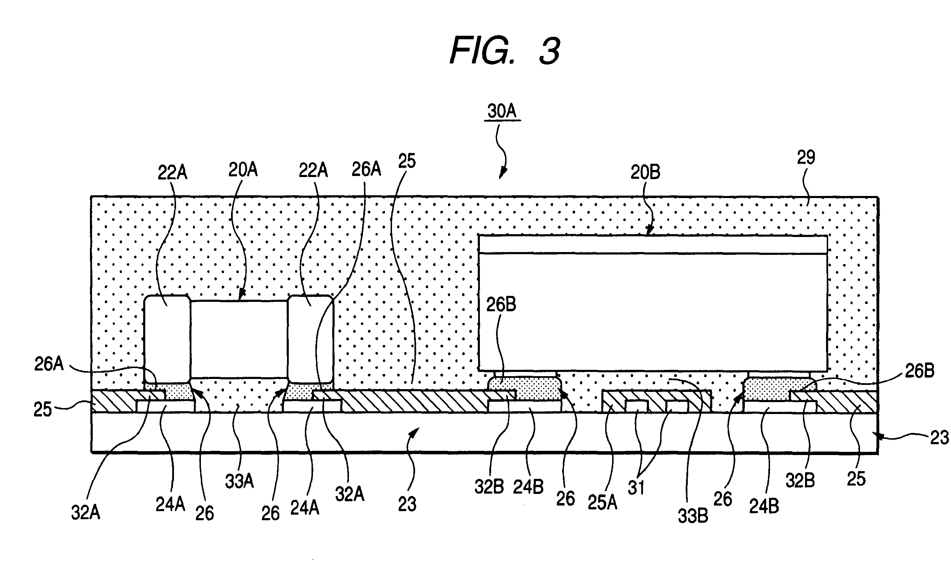

FIG.1 to FIG. 3 are views explaining an electronic device 30A as a first embodiment of the present invention. FIG.1 is a side view showing a state before a sealing resin 29 is provided to the electronic device 30A, FIG. 2 is a plan view of a substrate 23 constituting the electronic device 30A, and FIG.3 is a longitudinal sectional view of the electronic device 30A.

The electronic device 30A comprises packaging parts 20A, 20B, the substrate 23, the sealing resin 29, and the like. The packaging part 20A is a ceramic chip parts such as a resistor, a capacitor, or the like, for example, and packaging part electrodes 22A are formed on both sides of the packaging part 20A. Also, the packaging part 20B is an electronic element such as a SAW filter, an oscillator, or the like, for example, and packaging part electrocies 22B are formed on a lower surface of the packaging part 20B.

The substrate 23 is a printed-wiring board, for example, and foot patterns 24A, 24B are formed on a surface of the substrate 23. The foot patterns 24A are the electrode patterns used to mount the packaging part 20A, and the foot patterns 24B are the electrode patterns used to mount the packaging parts 20. Also, various wiring patterns 31 as well as the foot patterns 24A, 24B are formed on a surface of the substrate 23. In the present embodiment, the wiring patterns 31 are provided to positions that oppose to the packaging part 20B.

A solder resist 25 is formed on the surface of the substrate 23 to protect the wiring patterns 31. The solder resist 25 is provided to the surface of the substrate 23 such that, when the solder is applied, solder 26 is not deposited on conductors (e.g., the wiring patterns 31) other than the foot patterns 24A, 24B. The solder resist 25 is formed relatively easily in a desired shape by the screen printing, or the like.

As shown in FIG.2, opening portions 27A, 27B are formed in the solder resist 25. The opening portions 27A, 27B are formed to correspond to forming positions of the foot patterns 24A, 24B formed on the substrate 23. More particularly, the opening portion 27A is formed to correspond to the foot patterns 24A on which the packaging part 20A is mounted, and also the opening portions 27B are formed to correspond to the foot patterns 24B on which the packaging part 20B is mounted.

Also, a length L1 of the opening portion 27A in the arrow X direction in FIG. 2 is set shorter than a length L2 of the packaging part 20A (in FIG.2, its outer shape is indicated by a chain double-dashed line) in the arrow X direction in a mounted state (L2>L1). Also, two opening portions 27B are formed on the right and left sides in FIG.2 to put a lower resist 25A of the packaging part 20B between them. In this case, a length L3 between a left end portion and a right end portion containing two opening portions 27B in FIG. 2 is set shorter than a length L4 of the packaging part 208 (in FIG.2, its outer shape is indicated by a chain double-dashed line) in the arrow X direction in a mounted state (L4>L3).

Now, a relationship between the foot patterns 24A, 24B and the solder resist 25 will be mentioned hereunder. The present embodiment is constructed such that a part of the foot patterns 24A, 24B is covered with the solder resist 25.
Suppose hereunder that a portion of the solder resist 25 for covering a part of the foot patterns 24A is referred to as an overlapping portion 32A and a portion of the solder resist 25 for covering a part of the foot patterns 24B is referred to as an overlapping portion 32B.

Respective overlapping portions 32A, 32B are provided on outer positions of the foot patterns 24A, 24B. In the present embodiment, the overlapping portion 32A (32B) is provided to extend in the arrow X direction only in FIG.2, and a width dimension of the overlapping portion 32A is given by a width indicated by an arrow X1 (X2) in FIG.2.

The overlapping portions 32A, 32B are constructed such that they are positioned in areas of the packaging parts 20A, 20B in their mounted state (areas indicated by a chain double-dashed line in FIG.2). In other words, the overlapping portions 32A, 32B are constructed to oppose to the packaging parts 20A, 20B when the packaging parts 20A, 20B are mounted on the substrate 23.

Also, in the present embodiment, the solder resist 25 located between a pair of foot patterns 24A, 24A is not provided. Therefore, as shown in FIG.1, the packaging part 20A is faced directly to the substrate 23 before it is sealed with the sealing resin 29.

In contrast to this, the wiring patterns 31 are provided between the left and right foot patterns 24B on the side where the packaging part 20B is provided. In order to protect the wiring patterns 31, the lower resist 25A is formed between the left and right foot patterns 24B on the side where the packaging part 20B is provided.

The solder paste is applied onto the foot patterns 24A, 24B to mount the packaging parts 20A, 20B on the substrate 23. At this time, the solder paste is applied onto not only upper surfaces of the foot patterns 24A, 24B but also upper surfaces of the overlapping portions 32A, 32B.

Then, the packaging parts 20A, 20B are aligned with the substrate 23 such that the electrodes 22A, 22B are positioned on the foot patterns 24A, 24B onto which the solder paste is applied, and then the packaging parts 20A, 20B are fitted onto the substrate 23. In this state, the packaging parts 20A, 20B are temporarily fitted to the substrate 23 by the solder paste.

Then, the substrate 23 to which the packaging parts 20A, 20B are temporarily fitted is put into the reflow furnace, and then the reflow process is carried out. As a result, organic components in the solder paste are evaporated and the solder is melted. Then, the packaging part electrodes 22A, 22B of the packaging parts 20A, 20B are soldered to the foot patterns 24A, 24B with the solder 26 after the melted solder 26 is cooled/solidified.

FIG.1 shows a state that the packaging -arts 20A, 20B are secured to the foot patterns 24A, 24B with the solder 26. Here, the solder 26 in the present embodiment is mentioned hereunder. In the present embodiment, a part of the solder 26 is formed to run on the upper portion of the solder resist 25 (portion of the solder 26 formed to run on the upper portion of the solder resist 25 is referred to as running-on portions 26A, 26B respectively hereinafter).

In this manner, a part of the solder 26 is formed to run on the upper portion of the solder resist 25. Therefore, the packaging part 20A is positioned higher than the upper portion of the solder resist 25 by a thickness of the running-on portion 26A (indicated by an arrow ΔH1 in FIG.1) in its mounted state, and also the packaging part 20B is positioned higher than the upper portion of the solder resist 25 by a thickness of the running-on portion 26B (indicated by an arrow ΔH2 in FIG.1).

The thicknesses (ΔH1, ΔH2) of the running-on portions 26A, 26B can be adjusted by areas of the overlapping portions 32A, 32B overlapped on the foot patterns 24A, 24B (in other words, exposed areas of the foot patterns 24A, 24B), an applied amount of the solder 26, and the like.

Also, in order to form the running-on portion 26A, 26B (solder 26) on the solder resist 25 that has essentially a low affinity for the solder, it is important that in fact outwardly extruded portions of the foot patterns 24A, 24B should be positioned on as inner the side as possible of the packaging areas (indicated by a chain double-dashed line in FIG. 2) of the packaging parts 20A, 20B such that they are not positioned on the outer side from the packaging areas of the packaging parts 20A, 20B. Also, it is important that, when the substrate 23 onto which the packaging parts 20A, 20B are mounted is viewed from the top, the overlapping portions 32A, 32B should be provided in areas that are overlapped with the areas where the packaging part electrodes 22A, 22B are opposed to the foot patterns 24A, 24B.

With the above configuration, the running-on portion 26A, 26B can be prevented from leaking out from outer peripheries of the packaging parts 20A, 20B to the outer side. Accordingly, the running-on portion 26A, 26B can be held between the packaging parts 20A, 20B and the substrate 23 (the foot patterns 24A, 24B, the overlapping portions 32A, 32B).

As a result, the packaging parts 20A, 20B can be isolated more largely from the substrate 23 than the related art (see FIG.18 to FIG.23). More concretely, on the packaging side of the packaging part 20A, the solder resist 25 under the packaging position of the packaging part 20A is not provided. Thus, an isolation distance between the substrate 23 and the packaging part 20A is given by a distance indicated by an arrow Z1 in FIG.1.

Also, on the packaging side of the packaging part 20B, the lower resist 25A is formed between the packaging part 20B and the substrate 23 because of the presence of the wiring patterns 31. Thus, an isolation distance between a surface of the lower resist 25A and the lower surface of the packaging part 20B is given by a distance indicated by an arrow Z2 in FIG.1.

Both isolation distances Z1, Z2 can be increased large rather than the related art (ΔH indicated in FIG.20 and FIG.23). Concretely, the isolation distances Z1 Z2, although varied due to the exposed area of the foot pattern 24A, an applied amount of the solder 26, etc., can be set to 20 µm to 30 µm, for example.

As shown in FIG.3, the sealing resin 29 is formed to seal the packaging parts 20A, 20B provided onto the substrate 23. The sealing resin 29 is made of an epoxy resin, and is formed by using the transfer molding method, for example.

In the present embodiment, since the isolation distances Z1, Z2 between the packaging parts 20A, 20B and the substrate 23 can be set large as described above, the sealing resin 29 can be introduced without fail into spaces (33A, 33B) between the packaging parts 20A, 20B and the substrate 23. In particular, on the packaging side of the packaging part 20A, the sealing resin 29 can be introduced more surely because the solder resist 25 is not present between the packaging part 20A and the substrate 23.

In this way, in the electronic device 30A according to the present embodiment, since the sealing resin 29 is introduced into the spaces between the packaging parts 20A, 20B and the substrate 23, a clearance is never generated between the packaging parts 20A, 20B and the substrate 23. Therefore, even when the heating is applied upon mounting the electronic device 30A, and the like, a short-circuit between the foot patterns 24A, 24B via the solder 26 is never generated, and also the sealing resin 29 is never badly influenced by the expansion of the air in the clearance. As a result, reliability of the electronic device 30A can be improved.

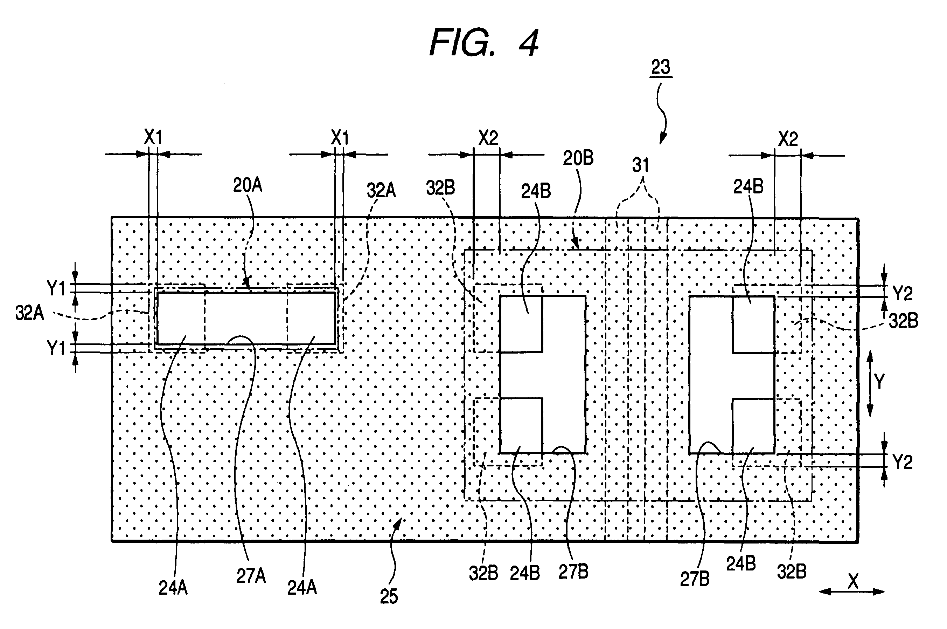

FIG.4 shows the substrate 23 provided to an electronic device as a variation of the first embodiment of the present invention. The first embodiment shown in FIG.2 is constructed such that the overlapping portions 32A, 32B are provided to extend in the arrow X direction in FIG.2 only. In contrast, this variation is characterized in that the overlapping portions 32A, 32B are provided to-extend not only in the arrow X direction in FIG.4 but also in the arrow Y direction in FIG.4.

In an example shown in FIG. 4, width dimensions of extended portions of the overlapping portions 32A, 32B in the arrow Y direction are set to widths indicated by arrows Y1, Y2 respectively. In this variation, the forming positions of the overlapping portions 32A, 32B are not limited to one side of the foot patterns 24A, 24B, and they may be formed on two sides.

Next, a second embodiment of the present invention will be explained hereunder.

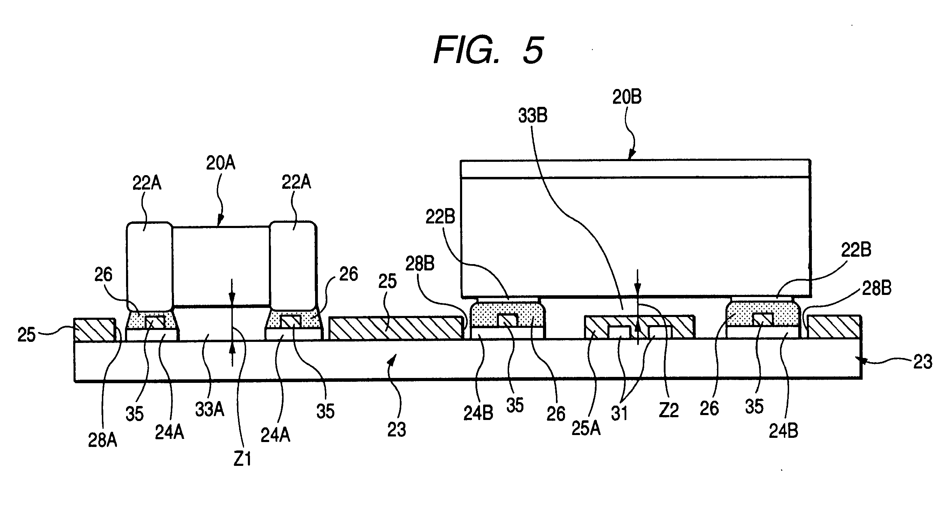

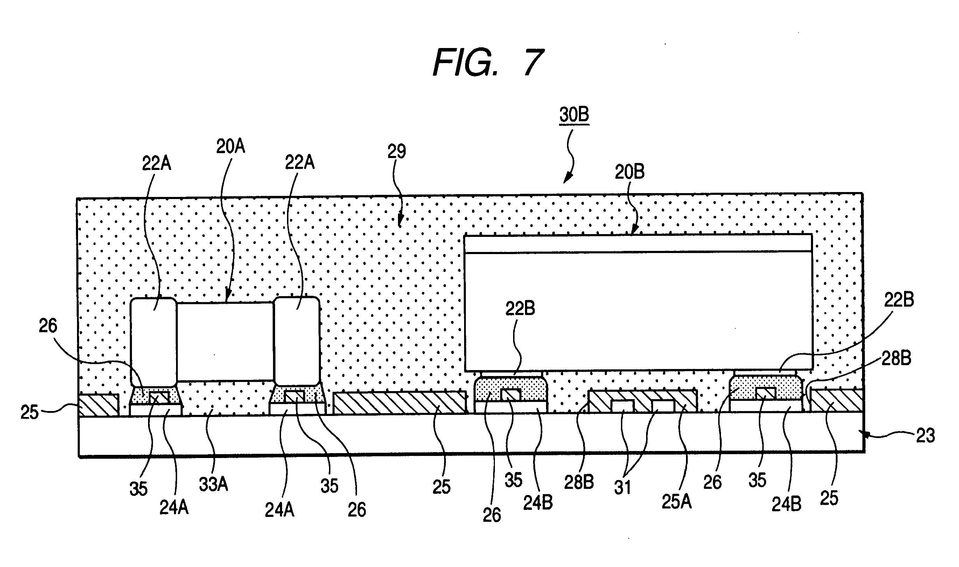

FIG. 5 to FIG. 7 are views explaining an electronic device 30B as a second embodiment the present invention. In FIG.5 to FIG.7, the same reference symbols are affixed to the same configuration as the electronic device 30A according to the first embodiment shown in FIG. 1 to FIG.3, and their explanation will be omitted herein.

The above electronic device 30A according to the first embodiment is characterized in that respective heights of the packaging parts 20A, 20B from the substrate 23 are increased since a part of the solder 26 is formed to run on the upper portion of the solder resist 25 to constitute the running-on portions 26A, 26B, and thus the sealing resin 29 can be introduced without fail into the spaces between the packaging parts 20A, 20B and the substrate 23.

In contrast, the electronic device 30B according to the present embodiment is characterized in that a buried member 35 is provided to the foot patterns 24A, 24B respectively. This buried member 35 is formed collectively upon forming the solder resist 25, and thus the buried member 35 is formed of the same material as the solder resist 25.

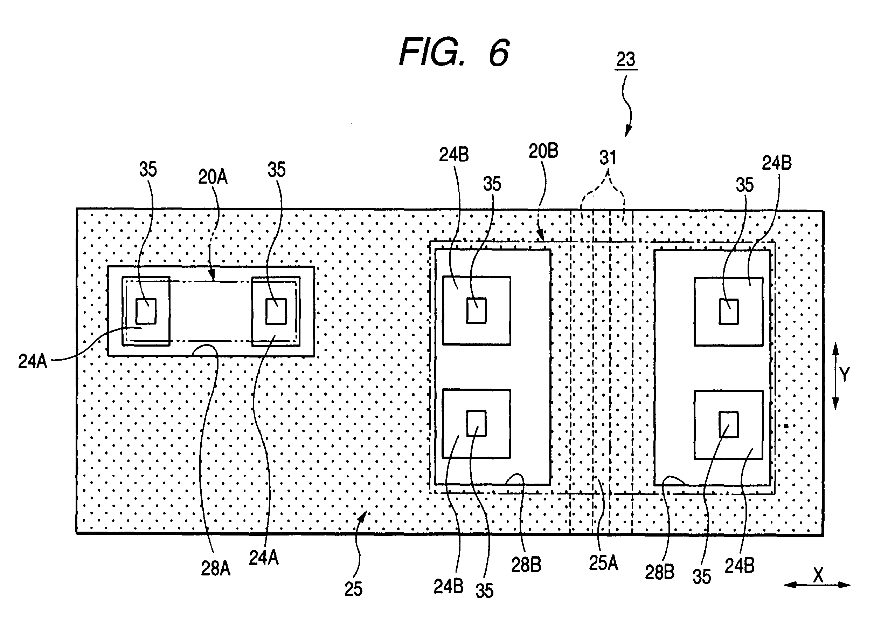

Also, as shown in FIG.6, the forming position of the buried member 35 is selected in almost center portions of the foot patterns 24A, 24B. As described above, the solder resist 25 can be formed easily by the screen printing, or the like, and printing (application) positions can be selected flexibly.

Therefore, the buried member 35 can be formed easily in the almost center portions of the foot patterns 24A, 24B. Also, since the buried member 35 is formed simultaneously with the solder resist 25, simplification of the manufacturing steps of the electronic device 30B can be achieved.

Also, in the present embodiment, the overlapping portions 32A, 32B are not provided on the foot patterns 24A, 24B. As shown in FIG.5 and FIG. 6, the foot patterns 24A, 24B are constructed to be exposed totally from opening portions 28A, 28B respectively.

Next, a process of mounting the packaging parts 20A, 20B on the substrate 23, which has the foot patterns 24A, 24B in which the buried member 35 is provided respectively, will be explained hereunder. In mounting the packaging parts 20A, 20B, first the solder paste is applied to the foot patterns 24A, 24B in which the buried member 35 is provided. At this time, the solder paste is applied to cover the buried member 35.

Then, the packaging parts 20A, 20B are aligned with the substrate 23 such that respective electrodes 22A, 22B are positioned on the foot patterns 24A, 24B, and then the packaging parts 20A, 20B are mounted/fitted onto the substrate 23. In this state, the packaging parts 20A, 20B are temporarily fitted to the substrate 23 by the solder paste.

Then, the substrate 23 is put into the reflow furnace, and then the reflow process is carried out. As a result, organic components in the solder paste are evaporated and the solder is melted. Then, the packaging part electrodes 22A, 22B of the packaging parts 20A, 20B are soldered to the foot patterns 24A, 24B with the solder 26 after the melted solder 26 is cooled/solidified.

Since the buried member 35 is formed in the almost center portions of the foot patterns 24A, 24B respectively, the melted solder 26 will assume the shape close to a sphere because of a surface tension when the solder 26 is melted. Therefore, even though the buried member 35 is formed of the solder resist, such buried member 35 is positioned in the inside of the solder 26. Then, the buried member 35 is buried in the solder 26 after the solder 26 is cooled in this state.

In this manner, since the buried member 35 is buried in the solder 26, a height of the solder 26 is increased higher than that of the solder 26 obtained when the buried member 35 is not provided. That is, a height of the solder 26 is increased by a height that corresponds to a volume of the buried member 35. Therefore, in the electronic device 30B according to the present embodiment, an isolation distance between the packaging parts 20A, 20B and the substrate 23 can be set large, and thus the sealing resin 29 can be introduced surely into the spaces between the packaging parts 20A, 20B and the substrate 23.

As a result, in the electronic device 30B according to the present embodiment, like the electronic device 30A according to the first embodiment, the clearance is never generated between the packaging parts 20A, 20B and the substrate 23. Therefore, even when the heating is applied upon mounting the electronic device 30B, and the like, a short-circuit between the foot patterns 24A, 24B via the solder 26 is never generated, and also the sealing resin 29 is never badly affected by the expansion of the air in the clearance. As a result, reliability of the electronic device 30B can be improved.

Next, a third embodiment of the present invention will be explained hereunder.

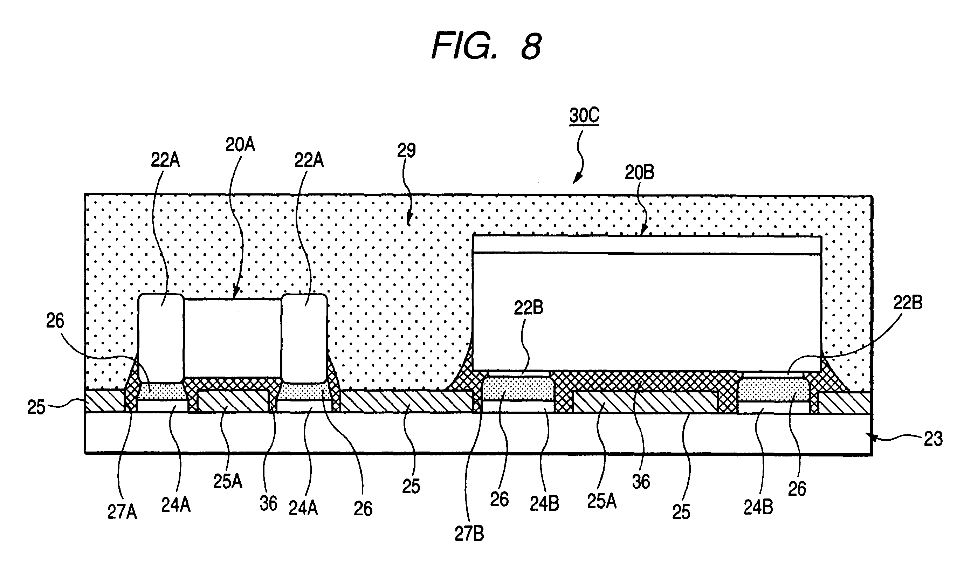

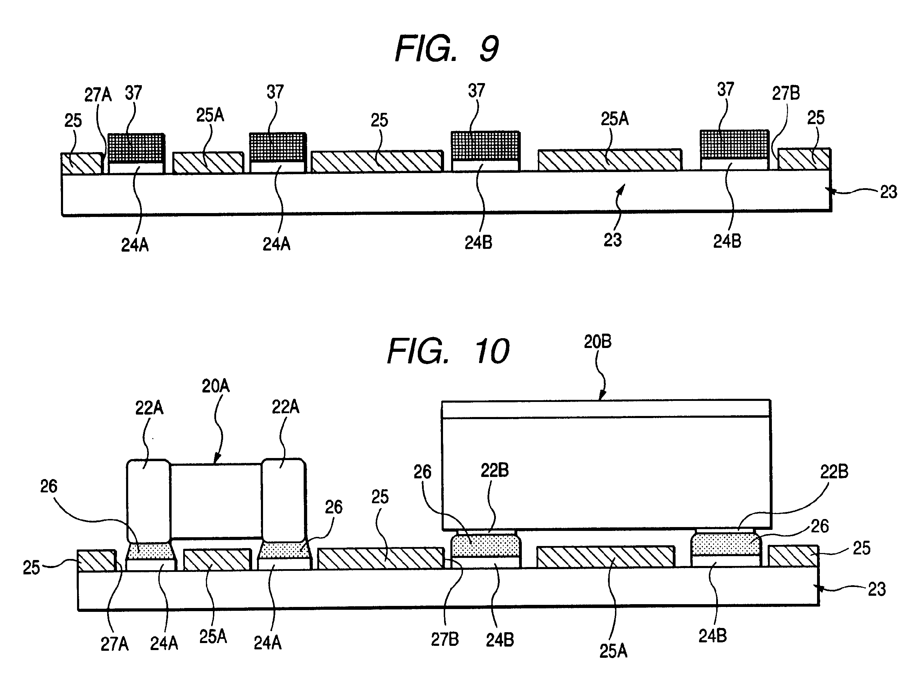

FIG.8 is a sectional view of an electronic device 30C as a third embodiment of the present invention. FIG.9 to FIG.11 are views explaining a method of manufacturing the electronic device 30C. In FIG.9 to FIG.11 used to explain the present embodiment, the same reference symbols are affixed to the same configuration as the electronic device 30A according to the first embodiment shown in FIG.1 to FIG.3, and their explanation will be omitted herein.

The electronic device 30C according to the present embodiment is characterized in that an underfill resin 36 is provided between the packaging parts 20A, 20B and the substrate 23. This underfill resin 36 is provided in isolation spaces between the lower resists 25A, which are provided between the neighboring foot patterns 24A and the neighboring foot patterns 24B respectively, and the packaging parts 20A, 20B. For this reason, the spaces between the packaging parts 20A, 20B and the substrate 23 are filled with the underfill resin 36 in a mounted state, and thus no clearance is formed in the spaces.

Therefore, even when the heating is applied upon mounting the electronic device 30C, and the like, a short-circuit between the foot patterns 24A, 24B via the solder 26 is never generated, and also the sealing resin 29 is never badly affected by the expansion of the air in the clearance. As a result, reliability of the electronic device 30C can be improved.

Next, the method of manufacturing the electronic device 30C will be explained hereunder. In order to manufacture the electronic device 30C, the substrate 23 on which the foot patterns 24A, 24B are formed previously in predetermined patterns respectively and also the opening portions 27A, 27B are formed in predetermined patterns in the solder resist 25 is prepared. In the present embodiment, the foot patterns 24A, 24B are formed such that they are exposed totally from the opening portions 27A, 27B formed in the solder resist 25.

First, a process of applying a solder paste 37 to the substrate 23 is executed (solder applying step). In this solder applying step, the solder paste 37 is printed on the foot patterns 24A, 24B exposed from the opening portions 27A, 27B by using the screen printing method. FIG. 9 shows a state that the solder paste 37 is provided on the foot patterns 24A, 24B by using the screen printing method.

Then, the packaging parts 20A, 20B are provided onto the foot patterns 24A, 24B on which the solder paste 37 is provided. More particularly, the packaging part electrodes 22A of the packaging part 20A are aligned with the foot patterns 24A, the packaging part electrodes 22B of the packaging part 20B are aligned with the foot patterns 24B, and the packaging part electrodes 22A, 22B are pushed against the solder paste 37. As a result, the packaging parts 20A, 20B are temporarily fitted onto the substrate 23 by an adhesive strength of the solder paste 37.

Then, the substrate 23 onto which the packaging parts 20A, 20B are temporarily fitted is put into the reflow furnace and is heated. Thus, the organic components in the solder paste 37 are vaporized and the solder is melted. Then, the packaging part electrodes 22A, 22B are secured to the foot patterns 24A, 24B with the solder 26 by executing the cooling (mounting step). FIG. 10 shows a state that the packaging part electrodes 22A, 22B are mounted onto substrate 23 with the solder 26 after the mounting step is finished. In this state, a clearance is formed between the packaging part electrodes 22A, 22B and the lower resists 25A respectively.

In this case, the packaging parts 20A, 20B are not sealed with the sealing resin 29 at a time of heating by using the reflowprocess. Therefore, the melted solder 26 can be freely moved, but such melted solder 26 never flows out from the upper surfaces of the foot patterns 24A, 24B by a surface tension even when the solder 26 is expanded. As a result, a short-circuit is never generated between the neighboring the foot patterns 24A and the neighboring the foot patterns 24B respectively.

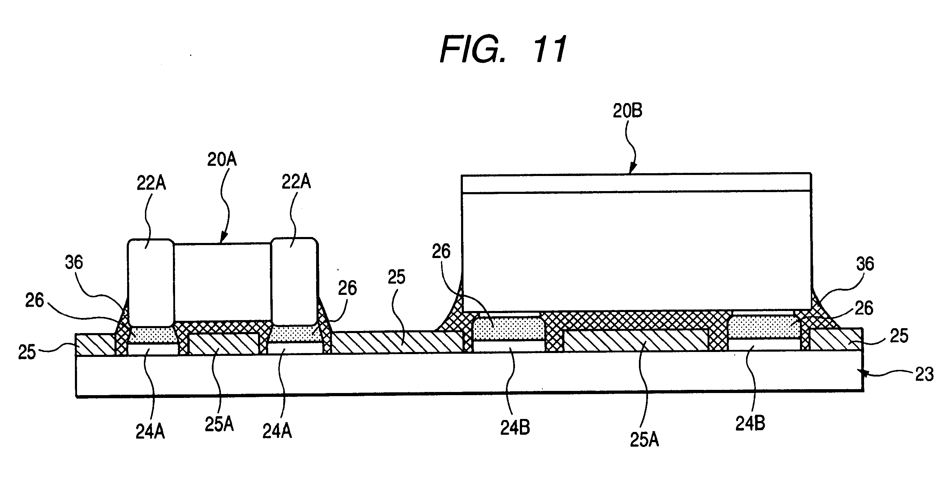

Then, the underfill resin 36 is filled in the spaces formed between the packaging part electrodes 22A, 22B and the substrate 23 (lower resists 25A) respectively (underfill filling step). This process of filling the underfill resin 36 can be executed by using the dispensers, for example. FIG. 11 shows the substrate 23 after the underfill filling step is finished.

Then, the sealing resin 29 for sealing the packaging part electrodes 22A, 22B is formed on the substrate 23 on which the underfill resin 36 is filled between the packaging part electrodes 22A, 22B and the lower resists 25A respectively (sealing step). This sealing resin 29 is an epoxy resin and is formed by using the transfer molding method, for example. At this time, no clearance is formed in the sealing resin 29 because the underfill resin 36 is filled between the packaging part electrodes 22A, 22B and the lower resists 25A respectively, as described above. The electronic device 30C shown in FIG. 8 can be manufactured via a series of above steps.

Next, a fourth embodiment of the present invention will be explained hereunder.

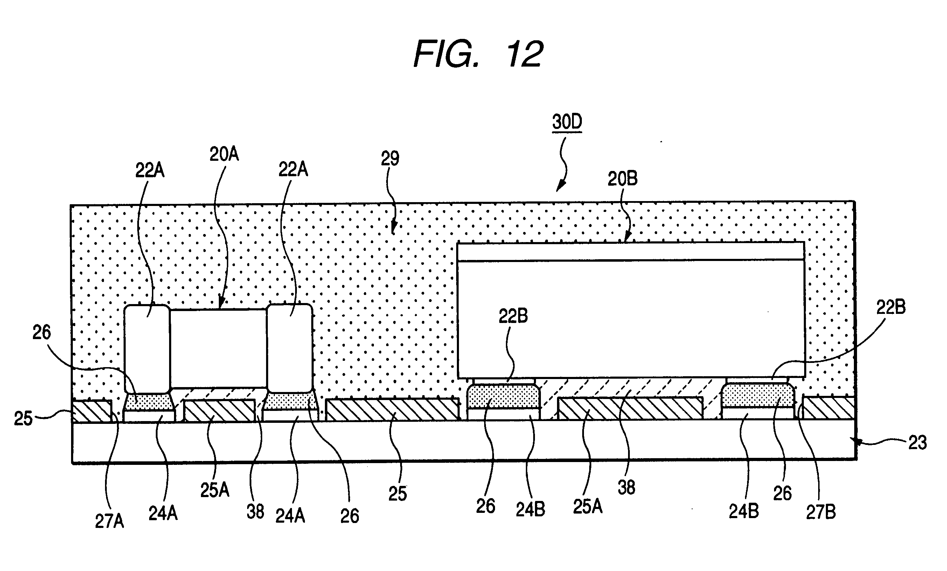

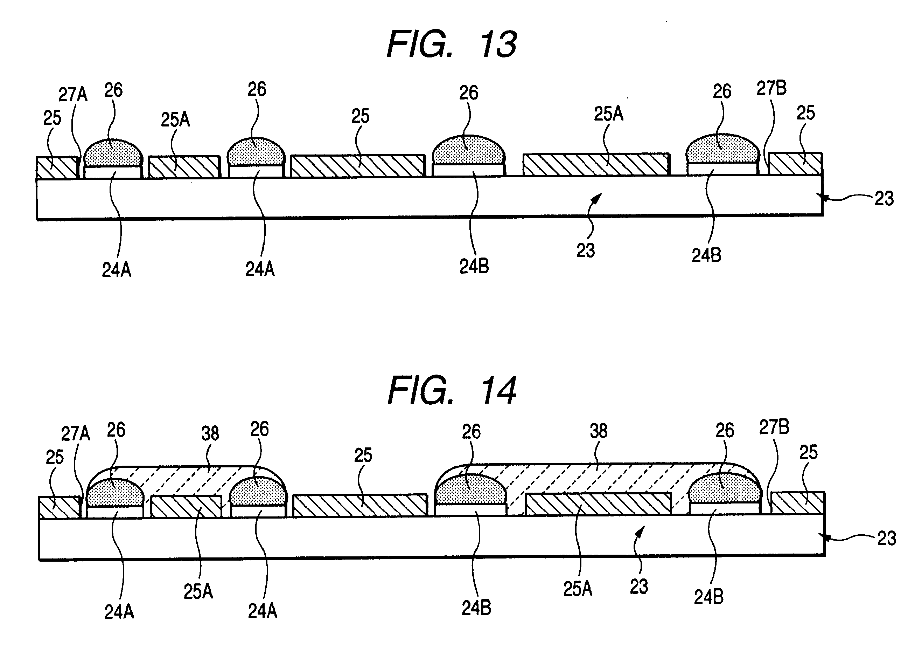

FIG.12 is a sectional view of an electronic device 30D as a fourth embodiment of the present invention. FIG.13 to FIG.15 are views explaining a method of manufacturing the electronic device 30D. In FIG. 13 to FIG. 15 used to explaining the present embodiment, the same reference symbols are affixed to the same configuration as the electronic device 30A according to the first embodiment shown in FIG. 1 to FIG. 3, and their explanation will be omitted herein.

The electronic device 30D according to the present embodiment is characterized in that a fluxfill resin 38 is filled in the spaces between the packaging parts 20A, 20B and the substrate 23. This fluxfill resin 38 is a thermosetting adhesive having an activation power necessary for the soldering. More particularly, the fluxfill resin 38 can fulfill a function as the adhesive when it is cured by the heating, and also can fulfill a function as the activator to remove an oxidation film on a surface of the solder and enhance fluidity of the melted solder when it is heated.

The fluxfill resin 38 is provided in isolation spaces between the packaging parts 20A, 20B and the lower resists 25A provided between the neighboring foot patterns 24A and the neighboring foot patterns 24B respectively. Therefore, the spaces between the packaging parts 20A, 20B and the substrate 23 are filled with the fluxfill resin 38 in the mounted state, and thus the clearance is never formed therein.

Therefore, even when the heating is applied in mounting the electronic device 30D according to the present embodiment, and the like, a short-circuit between the foot patterns 24A, 24B via the solder 26 is never generated, and also the sealing resin 29 is never harmfully influenced by the expansion of the air in the clearance. As a result, reliability of the electronic device 30D can be improved.

Next, the method of manufacturing the electronic device 30D will be explained hereunder. In order to manufacture the electronic device 30D, the substrate 23 on which the foot patterns 24A, 24B are formed previously in predetermined patterns respectively and also the opening portions 27A, 27B are formed in predetermined patterns in the solder resist 25 is prepared. In the present embodiment, the foot patterns 24A, 24B are formed such that they are exposed totally from the opening portions 27A, 27B formed in the solder resist 25.

First, a process of applying the solder paste 37 to the substrate 23 is executed (solder applying step). In this solder applying step, the solder paste 37 is printed on the foot patterns 24A, 24B exposed from the opening portions 27A, 27B by using the screen printing method. Also, in the present embodiment, the substrate 23 on which the solder paste 37 is applied onto the foot patterns 24A, 24B is put into the reflow furnace and the heating process is executed, and thus the organic components in the solder paste 37 are vaporized and the solder 26 is formed on the foot patterns 24A, 24B (solder applying step). FIG.13 shows the substrate 23 on which the solder 26 is formed on the foot patterns 24A, 24B.

Then, the fluxfill resin 38 is provided the position that lies under the packaging part 20A when mounted (between the neighboring foot patterns 24A) and the position that lies under the packaging part 20B when mounted (between the neighboring foot patterns 24B)(fluxfill resin providing step) . In the present embodiment, a film-like fluxfill resin is used as the fluxfill resin 38. Also, in the present embodiment, the film-like fluxfill resin 38 is arranged in the predetermined positions.

FIG.14 shows a state that the film-like fluxfill resin 38 is arranged on the substrate 23. As shown in FIG.14, the fluxfill resin 38 is arranged to cover upper areas of the solder 26 formed on the foot patterns 24A, 24B.

In this case, the fluxfill resin 38 is not limited to the film-like fluxfill resin. The liquid fluxfill resin 38 may be coated on the predetermined positions by a potting, or the like.

Then, the packaging parts 20A, 20B are arranged on the substrate 23 on which the fluxfill resin 38 is provided. More particularly, the packaging part electrodes 22A of the packaging parts 20A are aligned with the foot patterns 24A, the packaging part electrodes 22B of the packaging parts 20B are aligned with the foot patterns 24B, and the packaging part electrodes 22A, 22B are pushed against the fluxfill resin 38.

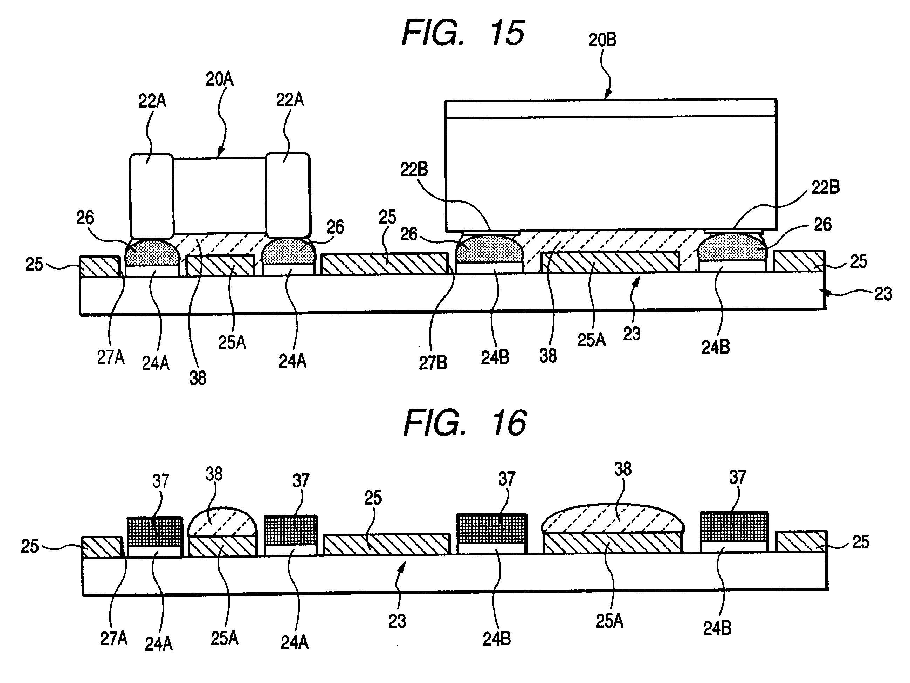

As a result, the packaging parts 20A, 20B are temporarily fitted onto the substrate 23 by an adhesive strength of the fluxfill resin 38. Also, the packaging part electrodes 22A, 22B of the packaging parts 20A, 2'OB come into contact with the solder 26. FIG.15 shows a state that the packaging parts 20A, 20B are temporarily fitted onto the substrate 23.

Then, the substrate 23 onto which the packaging parts 20A, 20B are temporarily fitted is put into the reflow fur.na.ce and is heated. Accordingly, the solder 26 is melted again. Then, the packaging part electrodes 22A, 22B are secured to the foot patterns 24A, 24B with the solder 26 by executing the cooling (mounting step).

At this time, the fluxfill resin 38 is thermally cured by the heating and the packaging parts 20A, 20B are adhered to the substrate 23. The packaging parts 20A, 20B are secured to the substrate 23 by an adhesive strength of the fluxfill resin 38 in addition to a jointing strength of the solder 26. For this reason, the packaging parts 20A, 20B are secured without fail to the substrate 23 and thus mechanical reliability of the electronic device 30D can be enhanced.

Also, since the fluxfill resin 38 contains the activator, an oxidation film formed on the surface of the solder 26 is removed and also the fluidity of the melted solder 26 can be increased when the solder 26 is melted by the heating. Hence, the packaging part electrodes 22A, 22B and the foot patterns 24A, 24B are connected more surely by the solder 26, and also reliability of the electronic device 30D can be enhanced in an electric aspect.

In the present embodiment, the packaging parts 20A, 20B are not sealed by the sealing resin 29. Therefore, a short-circuit is never generated between the neighboring the foot patterns 24A and the neighboring the foot patterns 24B respectively at a time of heating executed by the reflow process.

Then, the sealing resin 29 for sealing the packaging part electrodes 22A, 22B is formed on the substrate 23 on which the fluxfill resin 38 is interposed between the packaging part electrodes 22A, 22B and the lower resists 25A respectively (sealing step). This sealing resin 29 is an epoxy resin and is formed by using the transfer molding method, for example. At this time, no clearance is formed in the sealing resin 29 since the fluxfill resin 38 is filled between the packaging part electrodes 22A, 22B and the lower resists 25A respectively, as described above. The electronic device 30D shown in FIG.12 can be manufactured via a series of above steps.

FIG.16 and FIG.17 are views explaining a variation of a method of manufacturing the electronic device 30D as the fourth embodiment. In the method of manufacturing the electronic device 30D, the solder paste 37 is printed on the foot patterns 24A, 24B on the substrate 23, and then the fluxfill resin 38 and the packaging parts 20A, 20B are provided after the solder paste 37 is changed into the solder 26 by the heating.

In contrast, in the present variation, as shown in FIG.16, the solder paste 37 is printed on the foot patterns 24A, 24B by the screen printing, and then the fluxfill resin 38 is coated on the upper surfaces of the lower resists 25A. In this case, the printing of the solder paste 37 on the substrate 23 and the coating of the fluxfill resin 38 onto the lower resists 25A can be reversed in order.

After the solder paste 37 and the fluxfill resin 38 are provided to the substrate 23 as described above, the packaging parts 20A, 20B are aligned with the substrate 23 and then mounted thereon, like the above embodiments, as shown in FIG.17. Therefore, the packaging parts 20A, 20B are temporarily fitted to the substrate 23 by the solder paste 37 and the adhesive agent in the fluxfill resin 38.

Then, the substrate 23 to which the packaging parts 20A, 20B are temporarily fitted is put into the reflow furnace, and then the heating process is carried out. Accordingly, the packaging part electrodes 22A, 22B are soldered onto the foot patterns 24A, 24B with the solder 26, and also the packaging parts 20A, 20B are adhered/secured to the substrate 23 by the fluxfill resin 38. As a result, the electronic device 30D shown in FIG.12 can be manufactured.

## Claims

1. An electronic device, comprising:
a substrate on a surface of which electrode patterns and a solder resist are provided such that the electrode patterns are exposed from opening portions formed in the solder resist;
a packaging part mounted on the substrate, the packaging part having packaging part electrodes connected to the electrode patterns by solder; and
a sealing resin formed on the substrate to seal the packaging part,
wherein a part of the solder runs on an upper surface of the solder resist.

2. An electronic device according to claim 1,
wherein, when the substrate is viewed from a top, the solder resist has overlapping portions that are overlapped with areas in which the packaging part electrodes and the electrode patterns oppose to each other.

3. An electronic device according to claim 1,
wherein the solder resist is not provided in an area in which the packaging part and the substrate oppose to each other.

4. An electronic device, comprising:
a substrate on a surfa.ce of which electrode patterns and a solder resist are provided such that the electrode patterns are exposed from opening portions formed in the solder resist;
a packaging part mounted on the substrate, the packaging part having packaging part electrodes connected to the electrode patterns by solder; and
a sealing resin formed on the substrate to seal the packaging part,
wherein a buried member is provided into the electrode patterns respectively in a state that it is buried in the solder.

5. An electronic device according to claim 4,
wherein the buried member is formed of the solder resist.

6. An electronic device according to claim 4,
wherein, when the substrate is viewed from a top, the buried member is provided to areas in which the packaging part electrodes and the electrode patterns oppose to each other.

7. A method of manufacturing an electronic device, comprising: steps of
applying solder to electrode patterns on a substrate on a surface of which the electrode patterns and a solder resist are provided such that the electrode patterns are exposed from opening portions formed in the solder resist;
mounting packaging part electrodes, which are provided to a packaging part, on the electrode patterns by using the solder; and
forming a sealing resin, which seals the packaging parts, on the substrate,
wherein, before the mounting step is executed, a
thermosetting adhesive having an activation power necessary for soldering is provided to a position corresponding to a mounting position of the substrate, .on which the packaging part is mounted.
